# EUROPEAN PATENT SPECIFICATION

(11) **EP 4 344 368 B1**
(45) Date of publication and mention of the grant of the patent: **02.12.2026**
(21) Application number: 22803926.9
(22) Date of filing: 16.05.2022
(51) Int. Cl.: G06F 1/20

(54) **ELECTRONIC DEVICE CONTROL METHOD AND APPARATUS, AND ELECTRONIC DEVICE AND STORAGE MEDIUM**
VERFAHREN UND VORRICHTUNG ZUR STEUERUNG EINER ELEKTRONISCHEN VORRICHTUNG SOWIE ELEKTRONISCHE VORRICHTUNG UND SPEICHERMEDIUM
PROCÉDÉ ET APPAREIL DE COMMANDE DE DISPOSITIF ÉLECTRONIQUE, ET DISPOSITIF ÉLECTRONIQUE ET SUPPORT DE STOCKAGE

(30) Priority: 20.05.2021 CN 202110552639
(43) Date of publication of application: 27.03.2024
(73) Proprietor: Bitmain Technologies Inc., Beijing 100094 (CN)
(72) Inventor: WU, Chao, Beijing 100094 (CN); GUI, Wenming, Beijing 100094 (CN); ZHANG, Qiang, Beijing 100094 (CN); ZHOU, Zhaodi, Beijing 100094 (CN)
(74) Representative: Elzaburu S.L.P.
(86) International application number: PCT/CN2022/093109
(87) International publication number: WO 2022/242606

(56) References cited:
- WO-A1-2016/068158
- CN-A- 102 026 524
- CN-A- 103 213 492
- CN-A- 103 362 840
- CN-A- 107 165 871
- CN-A- 109 654 054
- CN-A- 110 454 906
- CN-A- 112 196 812
- JP-A- 2011 206 816
- US-A1- 2012 275 115
- US-A1- 2016 238 014
- US-A1- 2016 282 807

## Description

### TECHNICAL FIELD

The present disclosure relates to the technical field of electronics, and in particular, to an electronic device control method and apparatus, an electronic device, and a storage medium.

### BACKGROUND

An electronic device consumes energy during operation, and most of the consumed energy will be converted into heat. To protect the electronic device against failure or rapid aging due to overheating, a heat dissipation module, such as a fan, is usually arranged inside the device. Moreover, a vent is formed in a housing of the device, to facilitate air convection for heat dissipation.

However, in some cases, dust, foreign objects, or flying insects may enter the electronic device, which makes the device not clean enough, and thus results in a declined heat dissipation capability and other problems.

US2012/275115A1 provides an electronic device including a casing, a heat generating element, a heat dissipating element and a fan. The heat generating element is disposed in the casing. The heat dissipating element is disposed on the heat generating element. The fan is disposed on the heat dissipating element and is capable of rotating forward or reverse. When the electronic device in a first state is changed into a second state, the fan firstly rotates reverse to generate a first airflow for removing the dust in the casing. After the fan rotates reverse over a period of time, the fan stops from rotating reverse and starts to rotate forward to generate a second airflow for dissipating heat from the heat dissipating element.

US2016/238014A1 provides a control system including a motor, an interface circuit, a motor controller and a detection control circuit. The interface circuit receives and converts a pulse width modulation signal. The fan dissipates heat when the motor is operated in a forward rotation mode and eliminates dust when the motor is operated in a reverse rotation mode. The detection control circuit reads a duty cycle of the converted pulse width modulation signal in real time. When the motor is operated in the forward rotation mode, the detection control circuit drives the motor controller to control the rotation speed of the fan according to the duty cycle. If the duty cycle is lower than or equal to a first threshold value, the detection control circuit drives the motor controller to switch operation mode of the motor from the forward rotation mode to the reverse rotation mode.

### SUMMARY

The present invention is defined in the independent claims. Embodiments of the present disclosure provide an electronic device control method and apparatus, an electronic device, and a storage medium.

In a first aspect, an embodiment of the present disclosure provides an electronic device control method. The method includes:
selecting a target mode from optional modes of a fan of an electronic device, the optional modes including a cleaning mode and a heat dissipation mode, where in the cleaning mode, the fan provides at least two different air strengths, and in the heat dissipation mode, the fan provides a single air strength when a heat dissipation level is not switched;
generating a control signal based on the target mode; and
controlling, based on the control signal, the fan to provide an air strength.

Based on the above solution, the generating a control signal based on the target mode includes:
generating a first control signal if the target mode is the cleaning mode,
where the first control signal includes at least two pulse width modulation (PWM) signals with different duty cycles; or the first control signal includes at least two direct current (DC) control signals with different high voltage values.

Based on the above solution, the generating a control signal based on the target mode includes:
generating a second control signal if the target mode is the heat dissipation mode, where the second control signal is a PWM signal with a single duty cycle or a DC signal with a single voltage value.

Based on the above solution, the selecting a target mode from optional modes of a fan of an electronic device includes:
selecting the cleaning mode as the target mode at a cleaning time; and
selecting the heat dissipation mode as the target mode at a time other than the cleaning time.

Based on the above solution, the method further includes:
determining a cleaning delay; and
determining the cleaning time based on the cleaning delay.

Based on the above solution, the determining a cleaning delay includes at least one of:
determining the cleaning delay after the electronic device is powered on;
determining the cleaning delay after the electronic device is powered on and runs for a preset duration;
determining the cleaning delay after the electronic device has completed previous cleaning; and
determining the cleaning delay based on a predetermined period after the electronic device is powered on and has completed first-time cleaning.

Based on the above solution, the determining a cleaning delay includes at least one of:
determining the cleaning delay based on a randomized algorithm;
determining the cleaning delay based on a device number of the electronic device;
determining the cleaning delay based on a local area network address of the electronic device in a local area network where the electronic device is located; and
determining the cleaning delay based on a group number of a device group to which the electronic device belongs.

Based on the above solution, the running status information includes load status information indicating a load status of the electronic device and/or temperature status information indicating an internal temperature status of the electronic device; and
the method further includes:
determining, based on the load status information, a time at which a load rate of the electronic device is lower than a load threshold as the cleaning time;
   and/or
determining, based on the temperature status information, the time at which a temperature value of the powered-on electronic device is lower than a preset temperature value as the cleaning time.

Based on the above solution, the generating a control signal based on the target mode includes:
obtaining a minimum air strength required to dissipate heat from the electronic device if the target mode is the cleaning mode; and
generating the control signal based on the minimum air strength required to dissipate heat from the electronic device, where the control signal controls a minimum air strength provided by the fan to be greater than or equal to the minimum air strength required to dissipate heat from the electronic device.

In a second aspect, an embodiment of the present disclosure provides an electronic device control apparatus. The apparatus includes:
a selection module configured to select a target mode from optional modes of a fan of an electronic device, the optional modes including a cleaning mode and a heat dissipation mode, where in the cleaning mode, the fan provides at least two different air strengths, and in the heat dissipation mode, the fan provides a single air strength when a heat dissipation level is not switched;
a generation module configured to generate a control signal based on the target mode; and
a control module configured to control, based on the control signal, the fan to provide an air strength.

Based on the above solution, the generation module is specifically configured to generate a first control signal if the target mode is the cleaning mode,
where the first control signal includes at least two pulse width modulation (PWM) signals with different duty cycles; or
the first control signal includes at least two direct current (DC) control signals with different high voltage values.

Based on the above solution, the generation module is specifically configured to generate a second control signal if the target mode is the heat dissipation mode, where the second control signal is a PWM signal with a single duty cycle or a DC signal with a single voltage value.

Based on the above solution, the selection module is specifically configured to: select the cleaning mode as the target mode at a cleaning time; and select the heat dissipation mode as the target mode at a time other than the cleaning time.

Based on the above solution, the apparatus further includes:
a first determination module configured to determine a cleaning delay; and
a second determination module configured to determine the cleaning time based on the cleaning delay.

Based on the above solution, the first determination module is specifically configured to perform at least one of operations of:
determining the cleaning delay after the electronic device is powered on;
determining the cleaning delay after the electronic device is powered on and runs for a preset duration;
determining the cleaning delay after the electronic device has completed previous cleaning; and
determining the cleaning delay based on a predetermined period after the electronic device is powered on and has completed first-time cleaning.

Based on the above solution, the first determination module is specifically configured to perform at least one of operations of:
determining the cleaning delay based on a randomized algorithm;
determining the cleaning delay based on a device number of the electronic device;
determining the cleaning delay based on a local area network address of the electronic device in a local area network where the electronic device is located; and
determining the cleaning delay based on a group number of a device group to which the electronic device belongs.

Based on the above solution, the running status information includes load status information indicating a load status of the electronic device and/or temperature status information indicating an internal temperature status of the electronic device; and
the apparatus further includes a third determination module,
where the third determination module is specifically configured to: determine, based on the load status information, the time at which a load rate of the electronic device is lower than a load threshold as the cleaning time; and/or determine, based on the temperature status information, the time at which a temperature value of the powered-on electronic device is lower than a preset temperature value as the cleaning time.

Based on the above solution, the generation module is specifically configured to: obtain a minimum air strength required to dissipate heat from the electronic device if the target mode is the cleaning mode; and generate the control signal based on the minimum air strength required to dissipate heat from the electronic device, where the control signal controls a minimum air strength provided by the fan to be greater than or equal to the minimum air strength required to dissipate heat from the electronic device.

In a third aspect, an embodiment of the present disclosure provides an electronic device. The electronic device includes:
a memory configured to store processor-executable instructions; and
a processor connected to the memory,
where the processor is configured to perform the electronic device control method according to any of the foregoing technical solutions.

In a fourth aspect, an embodiment of the present disclosure provides a non-transitory computer-readable storage medium storing instructions that, when executed by a processor of a computer, enable the computer to perform the electronic device control method according to any of the foregoing technical solutions.

The technical solutions provided in the embodiments of the present disclosure may have the beneficial effects as follows.

In the technical solutions provided in the embodiments of the present disclosure, an electronic device includes a fan, and the fan has two optional working modes (e.g., optional modes), namely, a cleaning mode and a heat dissipation mode. In the heat dissipation mode, the fan mainly dissipates heat from the electronic device by means of a single air strength. In the cleaning mode, the fan may automatically switch the air strength. By controlling the switching of the air strength, the air strength inside the electronic device is changed. As a result, the dirt, foreign objects, or flying insects inside the electronic device may experience force changes under different air strengths, and the dirt, foreign objects, or flying insects stuck or adhered to the electronic device may also experience force changes, and are thus blown out of the device by means of the air strength provided by the fan in the case of the force changes, thereby implementing cleaning of the electronic device.

### BRIEF DESCRIPTION OF DRAWINGS

The accompanying drawings herein are incorporated into and constitute a part of the description, illustrate embodiments consistent with the present disclosure, and are used together with the description to explain the principles of the present disclosure.
FIG. 1 is a schematic flowchart of an electronic device control method according to an exemplary embodiment.
FIG. 2A is a schematic diagram of time domains of control signals generated by an electronic device according to an exemplary embodiment.
FIG. 2B is a schematic diagram of time domains of control signals generated by an electronic device according to an exemplary embodiment.
FIG. 3 is a schematic flowchart of an electronic device control method according to an exemplary embodiment.
FIG. 4 is a schematic diagram of running of an electronic device according to an exemplary embodiment.
FIG. 5 is a schematic diagram of a structure of an electronic device control apparatus according to an exemplary embodiment.
FIG. 6 is a schematic diagram of a structure of an electronic dual-color board according to an exemplary embodiment.

### DESCRIPTION OF EMBODIMENTS

Exemplary embodiments are described in detail herein, with examples shown in the accompanying drawings. Unless otherwise indicated, the same numbers in different figures represent the same or similar elements when the following description refers to the figures. Implementations described in the following exemplary embodiments do not represent all implementations consistent with the present disclosure. Instead, the implementations are merely examples of apparatuses consistent with some aspects of the present disclosure as detailed in the appended claims.

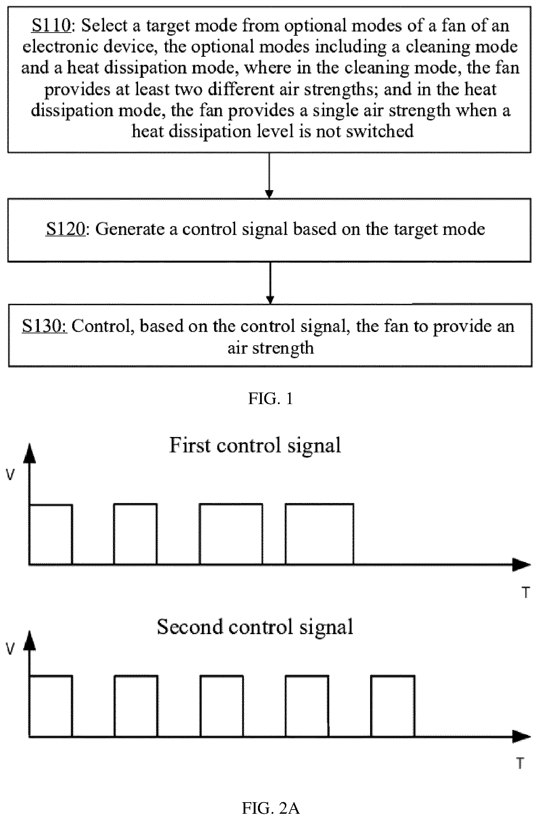

As shown in FIG. 1, an embodiment of the present disclosure provides an electronic device control method.

In S110, a target mode is selected from optional modes of a fan of an electronic device, the optional modes including a cleaning mode and a heat dissipation mode, where in the cleaning mode, the fan provides at least two different air strengths, and in the heat dissipation mode, the fan provides a single air strength when a heat dissipation level is not switched.

In S120, a control signal is generated based on the target mode.

In S130, the fan is controlled, based on the control signal, to provide an air strength.

The electronic device in this embodiment may be an electronic device including a fan and a heat generation module. The fan is originally used to dissipate heat from the heat generation module, but in this embodiment of the present disclosure, working modes are added to the fan, such that the fan has the cleaning mode in addition to the heat dissipation mode, and in the cleaning mode, the fan can provide for cleaning of the electronic device by switching at least two air strengths of the fan itself.

The electronic device provided in the embodiments of the present disclosure may be various types of electronic devices. For example, the electronic device may be a terminal device or a server. Exemplarily, the terminal device may include a personal computer (PC), etc. The PC may include a desktop PC, a notebook computer, a large-screen display device, etc. The server may be a rack server and/or a blade server.

In some embodiments, the electronic device may be an information technology (IT) device. The IT device includes various devices involved in IT computing. For example, the IT device may serve as a device of a blockchain node. Exemplarily, the IT device may be a miner.

The electronic device may include heat generation structures that generate heat in a working state, such as a processor and a memory. These heat generation structures may be the foregoing heat generation modules.

Exemplarily, the processor includes, but not limited to, a central processing unit, a microcontroller, an embedded controller, and/or a graphics processing unit.

Exemplarily, the memory includes, but not limited to, an internal memory, a magnetic disk, a flash memory, a hard disk, or other electronic components configured to temporally store and store information within the device.

In some embodiments, such an electronic device may include one fan. In some other embodiments, one electronic device is provided with a plurality of fans. The plurality of fans may be divided into two fan groups, one fan group including at least one fan. One fan group provides an air strength for outward air extraction, while the other fan group provides an air strength for inward air extraction, thereby achieving high-air-strength heat dissipation or high-air-strength cleaning.

Exemplarily, if the fan is working in the cleaning mode, the fan may provide at least a first air strength and a second air strength.

In some other embodiments, the fan working in the cleaning mode may further provide a third air strength, etc. in addition to the first air strength and the second air strength.

In this embodiment of the present disclosure, the fan working in the cleaning mode is not subjected to one-time air strength switching, but can repeatedly switch between at least two air strengths. Exemplarily, the fan periodically switches between the first air strength and the second air strength.

It is to be understood that the first air strength and the second air strength may both be used in a general sense. In some embodiments, the first air strength and the second air strength represent specific air strength values that are different from each other. In this case, exemplarily, the first air strength and the second air strength may respectively correspond to a maximum air strength and a minimum air strength that the fan provides. Exemplarily, when the fan provides the first air strength, the fan may rotate at a maximum rotational speed; and when the fan provides the second air strength, the fan may rotate at a non-zero minimum rotational speed. If the fan is working in the cleaning mode, the fan can switch between the maximum air strength and the minimum air strength, thereby implementing efficient cleaning inside the electronic device.

In some other embodiments, the first air strength and the second air strength represent different air strength ranges. For example, the first air strength and the second air strength represent different air strength ranges. In this case, if the fan is working in the cleaning mode, the fan repeatedly switches within the air strength ranges corresponding to the first air strength and the second air strength.

The dirt, foreign objects, flying insects, or other objects to be cleaned inside the electronic device will experience force changes or switching under different air strengths, and are thus blown out of the electronic device through an opening in a housing of the electronic device in the case of the force changes, thereby implementing internal cleaning of the electronic device.

In the heat dissipation mode, the fan may have a plurality of air strength gears. If the fan is working in the heat dissipation mode, the fan provides a single air strength when no air strength gear switching is performed, to implement stable heat dissipation.

In this embodiment of the present disclosure, the control signal generated based on the target working mode includes, but not limited to, a driving signal for the fan. For example, the control signal may be a power supply signal for a motor of the fan.

In some embodiments, S120 may include:
generating a first control signal if the target mode is the cleaning mode,
where the first control signal includes at least two pulse width modulation (PWM) signals with different duty cycles; or
the first control signal includes at least two direct current (DC) control signals with different high voltage values.

If the target mode is the cleaning mode, the first control signal is generated.

The first control signal may be divided into two types, which may be either a PWM signal or a DC signal.

Since the fan needs to switch the air strength when the fan is in the cleaning mode, the first control signal has a signal characteristic of allowing the fan to automatically switch between different air strengths. Exemplarily, the duty cycle of the PWM signal controls the rotational speed of the fan. Generally, a higher rotational speed provides for a greater air strength. In view of this, if the fan is working in the cleaning mode, the first control signal includes at least two PWM signals with different duty cycles. For example, it is to be understood that the PWM signals with two duty cycles that are included in the first control signal may have the same period but different duty cycles. For example, if one PWM signal has a duty cycle of 50%, and the other PWM signal has a duty cycle of 70%, the PWM signal with the duty cycle of 70% will drive the fan to rotate faster than the PWM signal with the duty cycle of 50%, thereby providing a greater air strength.

The PWM signals with different duty cycles that are included in the first control signal are alternated in a time domain. A duration that a PWM signal with one duty cycle occurs in the first control signal a single time is not less than one period corresponding to the PWM signal.

In this embodiment of the present disclosure, a first PWM signal and a second PWM signal may be PWM signals with the same duty cycle. Exemplarily, both the first PWM signal and the second PWM signal may be PWM signals with a duty cycle of 50%.

The first control signal may be a continuously distributed PWM signal in the time domain. In this embodiment of the present disclosure, the first PWM signal and the second PWM signal are provided as an example for illustration. The first control signal includes the first PWM signal and the second PWM signal, and the second period is different from the first period;
the first PWM signal is configured to control the fan to provide the first air strength; and
the second PWM signal is configured to control the fan to provide the second air strength.

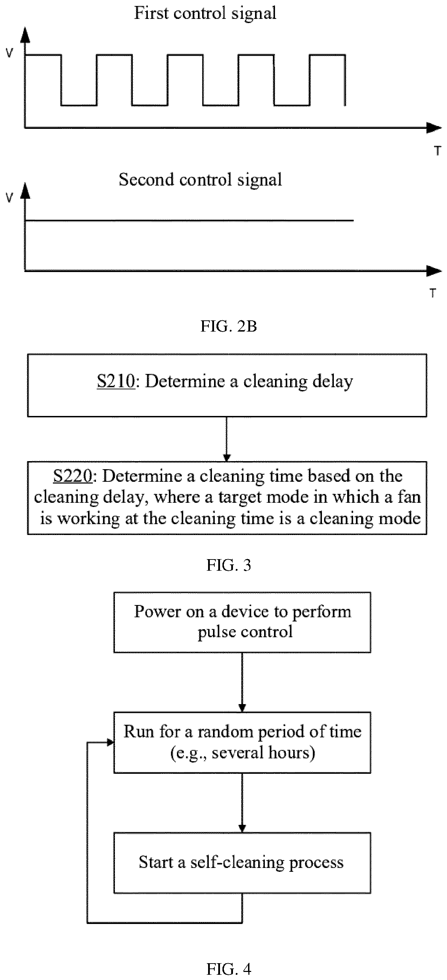

FIG. 2 illustrates a schematic diagram of a spaced distribution of a first PWM signal and a second PWM signal of a first control signal in a time domain. In FIG. 2, the vertical axis represents a voltage (V) axis, and the horizontal axis represents a time (T) axis. Based on FIG. 2, it can be seen that the first control signal has two PWM signals with different periods.

The first PWM signal and the second PWM signal may be PWM signals for controlling the rotational speed of the fan, and different duty cycles result in different rotational speeds of the fan, such that the fan can be controlled to provide different air strengths.

In the above example, the first control signal including two PWM signals with different duty cycles is taken as an example. During specific implementation, the first control signal may include PWM signals with three or more periods.

In some embodiments, the PWM signals included in the first control signal are switched, with a first duration as a switching duration, between the first PWM signal and the second PWM signal, where the first duration is at least greater than a larger period of the first PWM signal and the second PWM signal.

Here, the first duration is respectively greater than the larger period of the first PWM signal and the second PWM signal, which can ensure that each of durations for which the first PWM signal and the second PWM signal last in the first control signal a single time is at least one period.

Exemplarily, the first duration is a common multiple of the periods of the first PWM signal and the second PWM signal. For example, a ratio of the first duration to the period of the first PWM signal is S1, and a ratio of the second duration to the period of the second PWM signal is S2. S2 and S1 are both positive integers greater than or equal to 2.

In some embodiments, the first control signal is switched, with a preset number of periods, between the first PWM signal and the second PWM signal. For example, if the preset number of periods is P, the first control signal includes a continuous distribution of P first PWM signals followed by a continuous distribution of P second PWM signals, and this sequence continues in a cyclic manner.

In some embodiments, S210 may include:
generating the first control signal within a second duration if the target mode is the cleaning mode.

In an embodiment, the second duration is N times of the first duration, N being a positive integer greater than or equal to 2. In another embodiment, the second duration may be an integral multiple of a sum of durations of P first periods and P second periods.

The second duration is N times of the first duration. In this embodiment of the present disclosure, the first control signal lasts for the second duration at one time, and is switched, with the first duration as a switching period, between the first PWM signal and the second PWM signal, thereby controlling the fan to periodically switch the air strength with the first duration as the period within the second duration.

In this embodiment of the present disclosure, a range of values for the second duration may be measured in minutes. For example, the range of values for the second duration may be 5 minutes to 59 minutes. Exemplarily, the second duration may be set to 5 minutes, 10 minutes, 15 minutes, 20 minutes, etc, which are merely specific examples of the range of values for the second duration, and the second duration is not limited thereto during specific implementation. It is to be understood that assuming that the second duration is 10 minutes, the first control signal will last for 10 minutes, and the air strength provided by the fan will be switched between the first air strength and the second air strength for 10 minutes. Within the 10 minutes, objects inside the electronic device will be cleaned away after being subjected to alternating forces applied by the first air strength and the second air strength. Within 10 minutes, an instance of relatively complete and thorough cleaning can be completed without having excessive negative impacts on heat dissipation due to the switching of the air strength during the process.

The first control signal is a DC signal, and a voltage value corresponding to the DC signal is positively related to the air strength that the fan can provide. Therefore, the first control signal includes at least DC signals of two voltage values if the fan is working in the cleaning mode. For example, the first control signal is alternately switched between a 12V direct current voltage signal and a 6V direct current signal in the time domain.

Similarly, if the first control signal is a DC signal of two different voltage values, a duration for which a DC signal of one voltage value lasts in the first control signal a single time may allow the fan to rotate by at least W turns, where W may be any positive integer.

In some embodiments, S120 includes:
generating a second control signal if the target mode is the heat dissipation mode, where the second control signal is a PWM signal with a single duty cycle or a DC signal with a single voltage value.

The second control signal may be the PWM signal with the single duty cycle or the DC signal with the single voltage value.

Because the second control signal is the PWM signal with the single duty cycle or the DC signal with the single voltage value, the fan is driven by the second control signal to rotate at a constant speed after stabilization, thereby providing a stable single air strength.

FIG. 2A is a schematic diagram of comparison in the time domain when a first control signal and a second control signal generated by an electronic device are both PWM signals. As shown in FIG. 2A, the first control signal has at least two PWM signals with different duty cycles in the time domain, and the second control signal has only a PWM signal with one duty cycle in the time domain.

FIG. 2B is a schematic diagram showing that a first control signal and a second control signal generated by an electronic device are DC signals. In the time domain, the first control signal is a DC signal with two voltage values, and the second control signal is a DC signal with only a single voltage value. In both FIGS. 2A and 2B, the horizontal axis represents a time axis, and the vertical axis represents a voltage axis.

In some embodiments, S 110 may include:
selecting the cleaning mode as the target mode at a cleaning time; and
selecting the heat dissipation mode as the target mode at a time other than the cleaning time.

In this embodiment of the present disclosure, the cleaning time may generally refer to any time at which the fan implements self-cleaning of the electronic device by switching an air strength. The cleaning time may include a start time, an end time, and an intermediate time between the start time and the end time. The start time may be a time at which the fan starts to enter the cleaning mode. The end time may be a time at which the fan exits the cleaning mode. The intermediate time is a working time at which the fan is working in the cleaning mode after entering the cleaning mode.

In some embodiments, a cleaning duration corresponding to the cleaning time may be predetermined, or dynamically determined. If the cleaning duration is dynamically determined, a duration value may be randomly generated by using a randomized algorithm, etc. To ensure a minimum duration for cleaning, a cleaning duration may be randomly generated on the basis of generating the minimum cleaning duration by using the randomized algorithm.

The determination of the end time is related to the cleaning duration. For example, after the starting time, the end time is reached after the cleaning duration. The cleaning duration may be a pre-determined fixed duration. When the cleaning duration is dynamically determined, if it is determined that temperature of the electronic device reaches a temperature threshold at a certain moment of the cleaning time, it is considered that the end time for the cleaning time is reached. Alternatively, power of the electronic device is detected at the cleaning time, and if the power of the electronic device exceeds a power threshold, it may also be considered that the end time for the cleaning time is reached.

If the current time is the cleaning time, it is considered that the current target mode of the fan is the cleaning mode, otherwise, the current target mode of the fan is the heat dissipation mode. The time other than the cleaning time may be any time, other than the cleaning time, after the electronic device is powered on and the fan enters the working state.

In some embodiments, as shown in FIG. 3, the method further includes:
S210: determining a cleaning delay; and
S220: determining a cleaning time based on the cleaning delay, where a target mode in which a fan is working at the cleaning time is a cleaning mode.

In this embodiment of the present disclosure, the method may be applied to a device space with a large number of devices. A plurality of electronic devices located in the same device space share a power supply in the device space, such as at the same cleaning time, the problem of overloading of a power supply system in the device space is possibly caused.

Thus, in this embodiment of the present disclosure, the cleaning delay may first be determined, and the cleaning time is then determined based on the determined cleaning delay.

Exemplarily, the plurality of electronic devices in the device space determine cleaning delays at the same time, and at least some of the electronic devices have different cleaning delays. As such, at least some of the electronic devices have different cleaning times, such that a power supply load is balanced in the time domain, thereby reducing a power supply peak, and improving the power supply stability of the power supply system.

It is to be understood that at the time of determination of the cleaning delay, the cleaning time is reached after delaying the cleaning delay. That is, it may be considered that at the determination time of determining the cleaning delay, the time after a delay equal to the cleaning delay is the start time for the cleaning time.

In some embodiments, the determining a cleaning delay includes at least one of:
determining the cleaning delay after the electronic device is powered on;
determining the cleaning delay after the electronic device is powered on and runs for a preset duration;
determining the cleaning delay after the electronic device has completed previous cleaning; and
determining the cleaning delay based on a predetermined period after the electronic device is powered on and has completed first-time cleaning.

The electronic device will be started after being powered on. After the electronic device is successfully started, the cleaning delay is determined.

After the electronic device has been cleaned once, a cleaning delay of a next cleaning time is determined. At the very beginning of power-on of the electronic device, there is only a small amount of heat generated by the electronic device itself and accumulated. At this time, the use of the fan for heat dissipation to perform self-cleaning of the device by switching an air strength can reduce a negative impact of the fan during cleaning on heat dissipation of the electronic device as much as possible.

When the electronic device is powered on, many applications need to be started, or many initialization configurations, etc. of the device need to be completed, such that a system load rate of the electronic device may be high at the power-on time. In this case, the cleaning delay may be determined after the electronic device is powered on and stably runs for a period of time. The preset duration may be any duration value, for example, 10 minutes, half an hour, or other preset duration values. After being powered on and running for a period of time, the electronic device itself is running smoothly, and at this time, there is a small amount of heat generated by the device itself and accumulated after powering on and running for the preset duration. Therefore, in this case, the use of the fan for heat dissipation for cleaning inside the device can reduce the negative impact on heat dissipation of the electronic device.

In some embodiments, after the electronic device is powered on and then cleaned, the cleaning delay is periodically determined. Here, the period for periodically determining the cleaning delay is the above predetermined period. The predetermined period may be measured in days, such as half a day, one day, or two days. Certainly, the predetermined period may also be measured in hours, such as 3 hours, 6 hours, 12 hours, or 24 hours.

After the cleaning delay is determined, the time for determining the cleaning delay is taken as the start time, and the cleaning time is reached after a delay equal to the duration of the cleaning delay. Then, by generating the first control signal, the fan is controlled to switch between the first air strength and the second air strength so as to implement cleaning inside the electronic device.

In general, there are many methods for determining the time for determining the cleaning delay. Provided above are merely several possible embodiments, and the method are not limited to the above examples during specific implementation.

Exemplarily, cleaning delays corresponding to two adjacent cleaning times may be the same or different. The cleaning delays for the two adjacent cleaning times are the same, which indicates that the electronic device may periodically perform self-cleaning by using the fan of the electronic device itself.

In some embodiments, the determining a cleaning delay includes at least one of:
determining the cleaning delay based on a randomized algorithm;
determining the cleaning delay based on a device number of the electronic device;
determining the cleaning delay based on a local area network address of the electronic device in a local area network where the electronic device is located; and
determining the cleaning delay based on a group number of a device group to which the electronic device belongs.

If the electronic device determines the cleaning delay by using the randomized algorithm, a duration value corresponding to the cleaning delay is a random value calculated by the randomized algorithm.

The plurality of electronic devices in the device space have their respective device numbers, and if the cleaning delay is determined according to the same algorithm based on their respective device numbers, it can be ensured that different electronic devices may have different cleaning delays determined even at the same time point. Here, the device number includes, but not limited to, an international mobile equipment identity (IMEI), or a media access control (MAC) address of the electronic device. Typically, different devices have different IMEIs and MAC addresses, which allows for differentiation of the cleaning delays of devices even if they are located in the same device space, or in different device spaces connected to the same power supply system.

In some embodiments, the plurality of electronic devices may belong to the local area network. Within the local area network, local area network addresses are assigned, which addresses may be assigned internet protocol (IP) addresses of the local area network. Different electronic devices within the same local area network are assigned with different IP addresses, such that the cleaning delay is determined based on the IP addresses divided within the local area network, and different electronic devices may also determine different cleaning delays.

In some other embodiments, the local area network address further includes, but not limited to, a virtual local area network (VLAN) identity (ID).

In some embodiments, the plurality of electronic devices are divided into a plurality of device groups, and the device groups are assigned with group numbers. Accordingly, the electronic devices may determine the cleaning delays according to their respective group numbers. If the group numbers are different, different cleaning delays are determined at the same time when the same determining algorithm is used.

If the cleaning delays are different, the plurality of electronic devices do not control, at the same time, air strength changes of the fan for self-cleaning of the devices.

In some embodiments, the determining a cleaning time includes:
determining running status information of the electronic device; and
determining the cleaning time based on the running status information.

The cleaning time is determined based on the running state information of the electronic device itself. The running state information may indicate a load status and/or a temperature status, etc.

Determining the cleaning time based on the running status information can minimize the negative impact of reusing the fan for heat dissipation on heat dissipation.

In some embodiments, the running status information includes load status information indicating a load status of the electronic device and/or temperature status information indicating an internal temperature status of the electronic device; and

The determining the cleaning time based on the running state includes:
determining, based on the load status information, a time at which a load rate of the electronic device is lower than a load threshold as the cleaning time;
   and/or
determining, based on the temperature status information, the time at which a temperature value of the powered-on electronic device is lower than a preset temperature value as the cleaning time.

If the electronic device itself has a relatively low load, there is a small probability of heat accumulation within a short period of time. In this case, the fan may be mainly used for self-cleaning of the device.

If the electronic device itself has a relatively low temperature, there is a small probability that the device itself generates heat and then causes the temperature to sharply rise to a higher temperature. In this case, similarly, the air strength of the fan can be adjusted for the self-cleaning of the device.

In some embodiments, S120 may further include:
obtaining a minimum air strength required to dissipate heat from the electronic device if the target mode is the cleaning mode; and
generating the control signal based on the minimum air strength required to dissipate heat from the electronic device, where the control signal controls a minimum air strength provided by the fan to be greater than or equal to the minimum air strength required to dissipate heat from the electronic device.

The determining the minimum air strength required for the electronic device may include:
determining a minimum air strength required to maintain the temperature of the electronic device to be less than or equal to a preset temperature without overheating based on a current temperature of the electronic device, an environment temperature of an environment where the electronic device is located, and a working frequency of a heat generation module in the electronic device. The heat generation module includes, but not limited to, a processor and/or a memory, etc. The memory includes, but not limited to, an internal memory, etc. The processor includes, but not limited to, a CPU, a GPU, or a computing power board.

Where the control signal is generated when the target mode is the cleaning mode, the minimum air strength required to dissipate heat from the electronic device is considered, such that the minimum air strength provided by the fan is not less than the minimum air strength required for the electronic device, thereby guaranteeing a heat dissipation effect and also achieving a cleaning effect.

Exemplarily, in the cleaning mode, the fan switches between at least two air strengths not less than the minimum air strength required to dissipate heat from the electronic device.

An embodiment provides an electronic device control method, which may include: generating a first control signal; and
controlling, based on the first control signal, an air strength provided by a fan to be switched between a first air strength and a second air strength, where the second air strength is different from the first air strength.

The first control signal is configured to control an air outflow strength of the fan. For example, a higher rotational speed of the fan indicates a greater air outflow strength of the fan.

In this embodiment of the present disclosure, the first control signal controls the air strength provided by the fan to be switched between the first air strength and the second air strength periodically, instead of being switched between the first air strength and the second air strength at one time. The first control signal controls the air strength provided by the fan to be periodically switched between the first air strength and the second air strength at least M times, M here being a positive integer greater than or equal to 2.

Because the second air strength is different from the first air strength, the dirt, foreign objects, flying insects, or other objects to be cleaned inside the electronic device will experience force changes or switching under different air strengths, and are thus blown out of the electronic device through an opening in a housing of the electronic device in the case of the force changes, thereby implementing internal cleaning of the electronic device.

Generally, a fan of an IT device is designed to mainly focus to heat dissipation performance. By increasing an air circulation speed, the heat dissipation efficiency of the device is improved. To ensure system safety, the impact of dust is reduced by maintaining the environment of a machine room.

In this embodiment of the present disclosure, a fan control unit is added to the IT device, and a pulsed airflow is formed by utilizing a maximum air strength and the minimum air strength of the fan, thereby achieving the purpose of cleaning dust away. The fan control unit may be implemented by various functional modules capable of processing information in devices such as the CPU.

After a system of the IT device is powered on, pulse cleaning is immediately performed once, to update the state of the computing power board. The pulse cleaning herein is a process of using high-frequency periodic switching of a pulse signal to control the switching of the air strength of the fan, to implement cleaning, referred to as pulse cleaning.

To prevent pulsed airflows from being simultaneously formed for all devices, thus causing stress on power supply of the machine room, after being powered on, each device undergoes a random delay before pulse cleaning (measured in hours).

According to the solution provided in this embodiment of the present disclosure, light dust and insect bodies that may affect a circuit of the computing power board can be effectively cleaned away.

After the IT device runs for a long time, dust will be accumulated inside the system due to static electricity, affecting heat dissipation. Operation and maintenance personnel are then required to perform irregular cleaning to ensure system cleanliness and safety.

To lower the impact of dust on the system running for a long time, the pulsed airflow is used to clean the dust and foreign objects attached to the interior of the system, which increases the life of the system and also reduces the difficulty and workload of operation and maintenance.

In the solution provided in this embodiment of the present disclosure, a separate self-cleaning process is created to monitor the system state, and the dust attached to the computing power board is cleaned away by means of pulse control of the fan in two cases.

The computing power board may be a circuit board installed with the CPU, the GPU, or other processors having a computing function. The circuit board here is a type of the foregoing heat generation module.

In the solution provided in this embodiment of the present disclosure, a separate self-cleaning process is created to monitor the system state, and the dust attached to the computing power board is cleaned away by means of pulse control of the fan in two cases.

In the solution provided in this embodiment of the present disclosure, dust accumulation caused by static electricity can be effectively reduced, and insects accidentally entering the miner can also be effectively removed and cleared. The electronic device including the IT device provided in this embodiment of the present disclosure is running, as shown in FIG. 4. The device is powered on, and the device performs pulse control after being powered on, so as to generate the foregoing first control signal and/or second control signal. Here, both the first control signal and the second control signal are PWM signals for controlling the fan in the electronic device.

After the device is powered on and runs for a random period of time, for example, after the device is powered on and runs for several hours, a self-cleaning process is started.

Here, the self-cleaning process may include:
controlling, by means of the pulse control, the fan to alternately switch between different air strengths, so as to implement cleaning inside the device.

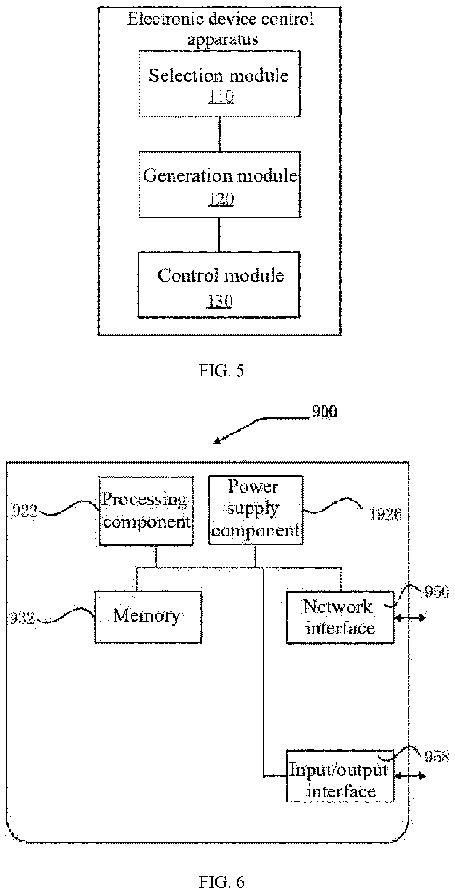

As shown in FIG. 5, an embodiment of the present disclosure provides an electronic device control apparatus. The apparatus includes:
a selection module 110 configured to select a target mode from optional modes of a fan of an electronic device, the optional modes including a cleaning mode and a heat dissipation mode, where in the cleaning mode, the fan provides at least two different air strengths, and in the heat dissipation mode, the fan provides a single air strength when a heat dissipation level is not switched;
a generation module 120 configured to generate a control signal based on the target mode; and
a control module 130 configured to control, based on the control signal, the fan to provide an air strength.

In some embodiments, the selection module 110, the generation module 120, and the control module 130 may be program modules. After the program modules are executed by a processor, the functions of any of the above modules can be implemented.

In some other embodiments, the selection module 110, the generation module 120, and the control module 130 may be combined software and hardware modules. The combined software and hardware modules include, but not limited to, various programmable arrays, and the programmable arrays include, but not limited to, a field-programmable array and/or a complex programmable array.

In still other embodiments, the selection module 110, the generation module 120, and the control module 130 may further include pure hardware modules. The pure hardware modules include, but not limited to, application-specific integrated circuits.

In some embodiments, the generation module 120 is specifically configured to generate a first control signal if the target mode is the cleaning mode,
where the first control signal includes at least two pulse width modulation (PWM) signals with different duty cycles; or
the first control signal includes at least two direct current (DC) control signals with different high voltage values.

In some embodiments, the generation module 120 is specifically configured to generate a second control signal if the target mode is the heat dissipation mode, where the second control signal is a PWM signal with a single duty cycle or a DC signal with a single voltage value.

In some embodiments, the selection module 110 is specifically configured to: select the cleaning mode as the target mode at a cleaning time; and select the heat dissipation mode as the target mode at a time other than the cleaning time.

In some embodiments, the apparatus further includes:
a first determination module configured to determine a cleaning delay; and
a second determination module configured to determine the cleaning time based on the cleaning delay.

In some embodiments, the first determination module is specifically configured to perform at least one of operations of:
determining the cleaning delay after the electronic device is powered on;
determining the cleaning delay after the electronic device is powered on and runs for a preset duration;
determining the cleaning delay after the electronic device has completed previous cleaning; and
determining the cleaning delay based on a predetermined period after the electronic device is powered on and has completed first-time cleaning.

In some embodiments, the first determination module is specifically configured to perform at least one of operations of:
determining the cleaning delay based on a randomized algorithm;
determining the cleaning delay based on a device number of the electronic device;
determining the cleaning delay based on a local area network address of the electronic device in a local area network where the electronic device is located; and
determining the cleaning delay based on a group number of a device group to which the electronic device belongs.

In some embodiments, the running status information includes load status information indicating a load status of the electronic device and/or temperature status information indicating an internal temperature status of the electronic device; and
the apparatus further includes a third determination module,
where the third determination module is specifically configured to: determine, based on the load status information, the time at which a load rate of the electronic device is lower than a load threshold as the cleaning time; and/or determine, based on the temperature status information, the time at which a temperature value of the powered-on electronic device is lower than a preset temperature value as the cleaning time.

In some embodiments, the generation module 120 is specifically configured to: obtain a minimum air strength required to dissipate heat from the electronic device if the target mode is the cleaning mode; and generate the control signal based on the minimum air strength required to dissipate heat from the electronic device, where the control signal controls a minimum air strength provided by the fan to be greater than or equal to the minimum air strength required to dissipate heat from the electronic device.

An embodiment of the present disclosure provides an electronic device. The electronic device includes:
a memory configured to store processor-executable instructions; and
a processor connected to the memory,
where the processor is configured to perform an electronic device control method according to any of the foregoing technical solutions.

The processor may include various types of storage media. The storage media are non-transitory computer storage media capable of continuing to memorize information stored on the electronic device when the electronic device is powered off.

Herein, the electronic device includes the foregoing mobile terminal or server. The processor and the memory included in the electronic device are a type of the foregoing heat generation module, and the electronic device further includes a fan. The fan, the processor, and the memory are all located in a housing of the electronic device.

The processor may be connected to the memory through a bus, etc., and is configured to read executable programs stored on the memory, such as to perform at least one of the methods shown in FIGS. 1, 3, and 4.

An embodiment of the present disclosure illustrates a structure of an electronic device. Referring to FIG. 6, a base station of the electronic device 900 is shown. The electronic device 900 includes: a processing component 922, which further includes one or more processors; and a memory resource represented by a memory 932, which is configured to store instructions executable by the processing component 922, such as an application program. The application program stored in the memory 932 may include one or more modules each corresponding to a set of instructions. In addition, the processing component 922 is configured to perform instructions so as to perform any of the foregoing methods applied to the base station, such as at least one of the methods shown in FIGS. 6 to 8.

The electronic device 900 may further include a power supply component 926 configured to perform power supply management of the electronic device 900, a wired or wireless network interface 950 configured to connect the electronic device 900 to the Internet, and an input/output (I/O) interface 958. The electronic device 900 may be operated based on an operating system stored in the memory 932, such as Windows Server TM, Mac OS XTM, UnixTM, LinuxTM, FreeBSDTM, or the like.

An embodiment of the present disclosure provides a non-transitory computer-readable storage medium storing instructions that, when executed by a processor of a user equipment (UE), enable the UE to perform the electronic device control method according to any of the foregoing embodiments, such as to perform at least one of the electronic device control methods shown in FIGS. 1, 3, and 4.

In an embodiment, the electronic device control method may include: selecting a target mode from optional modes of a fan of an electronic device, the optional modes including a cleaning mode and a heat dissipation mode, where in the cleaning mode, the fan provides at least two different air strengths, and in the heat dissipation mode, the fan provides a single air strength when a heat dissipation level is not switched; generating a control signal based on the target mode; and controlling, based on the control signal, the fan to provide an air strength.

It is to be understood that the generating a control signal based on the target mode includes: generating a first control signal if the target mode is the cleaning mode, where the first control signal includes at least two pulse width modulation (PWM) signals with different duty cycles; or the first control signal includes at least two direct current (DC) control signals with different high voltage values.

It is to be understood that the generating a control signal based on the target mode includes:
generating a second control signal if the target mode is the heat dissipation mode, where the second control signal is a PWM signal with a single duty cycle or a DC signal with a single voltage value.

It is to be understood that the selecting a target mode from optional modes of a fan of an electronic device includes: selecting the cleaning mode as the target mode at a cleaning time; and selecting the heat dissipation mode as the target mode at a time other than the cleaning time.

It is to be understood that the method further includes: determining a cleaning delay; and determining the cleaning time based on the cleaning delay.

It is to be understood that the determining a cleaning delay includes at least one of: determining the cleaning delay after the electronic device is powered on; determining the cleaning delay after the electronic device is powered on and runs for a preset duration; determining the cleaning delay after the electronic device has completed previous cleaning; and determining the cleaning delay based on a predetermined period after the electronic device is powered on and has completed first-time cleaning.

It is to be understood that the determining a cleaning delay includes at least one of: determining the cleaning delay based on a randomized algorithm; determining the cleaning delay based on a device number of the electronic device; determining the cleaning delay based on a local area network address of the electronic device in a local area network where the electronic device is located; and determining the cleaning delay based on a group number of a device group to which the electronic device belongs.

It is to be understood that the running status information includes load status information indicating a load status of the electronic device and/or temperature status information indicating an internal temperature status of the electronic device; and the method further includes: determining, based on the load status information, the time at which a load rate of the electronic device is lower than a load threshold as the cleaning time; and/or determining, based on the temperature status information, the time at which a temperature value of the powered-on electronic device is lower than a preset temperature value as the cleaning time.

It is to be understood that the generating a control signal based on the target mode includes: obtaining a minimum air strength required to dissipate heat from the electronic device if the target mode is the cleaning mode; and generating the control signal based on the minimum air strength required to dissipate heat from the electronic device, where the control signal controls a minimum air strength provided by the fan to be greater than or equal to the minimum air strength required to dissipate heat from the electronic device.

In some other embodiments, the electronic device control method is used for cleaning an electronic device including a fan and a heat generation module, where the fan is used for dissipating heat from the heat generation module. The device control method includes: generating a first control signal; and controlling, based on the first control signal, an air strength provided by a fan to be switched between a first air strength and a second air strength, where the second air strength is different from the first air strength.

It is to be understood that the first control signal includes a pulse width modulation (PWM) signal with a first period and a PWM signal with a second period where the second period is different from the first period;
the PWM signal with the first period is configured to control the fan to provide the first air strength; and
the PWM signal with the second period is configured to control the fan to provide the second air strength.

It is to be understood that the PWM signals included in the first control signal are switched, with a first duration as a switching duration, between the PWM signal with the first period and the PWM signal with the second period, where the first duration is at least greater than the larger one of the first period and the second period.

It is to be understood that the generating a first control signal includes generating the first control signal within a second duration, where the second duration is N times of the first duration, N being a positive integer greater than or equal to 2.

It is to be understood that the method further includes determining a cleaning time, and the generating a first control signal includes generating the first control signal at the cleaning time.

Based on the above solution, the determining a cleaning time includes: determining a cleaning delay; and determining the cleaning time based on the cleaning delay.

It is to be understood that the determining a cleaning delay includes at least one of:
determining the cleaning delay after the electronic device is powered on;
determining the cleaning delay after the electronic device is powered on and runs for a preset duration;
determining the cleaning delay after the electronic device has completed previous cleaning; and
determining the cleaning delay based on a predetermined period after the electronic device is powered on and has completed first-time cleaning.

It is to be understood that the determining a cleaning delay includes at least one of:
determining the cleaning delay based on a randomized algorithm;
determining the cleaning delay based on a device number of the electronic device;
determining the cleaning delay based on a local area network address of the electronic device in a local area network where the electronic device is located; and
determining the cleaning delay based on a group number of a device group to which the electronic device belongs.

It is to be understood that the method further includes:
generating a second control signal after the electronic device is cleaned, where the second control signal includes a PWM signal with a single period, and is configured to control the fan to provide an air strength uniformly.

It is to be understood that the first air strength includes a maximum air strength that the fan can provide; and
the second air strength includes a minimum air strength that the fan can provide.

It is to be understood that the determining a cleaning time includes: determining running status information of the electronic device; and determining the cleaning time based on the running status information.

It is to be understood that the running status information includes load status information indicating a load status of the electronic device and/or temperature status information indicating an internal temperature status of the electronic device; and
The determining the cleaning time based on the running state includes: determining, based on the load status information, the time at which a load rate of the electronic device is lower than a load threshold as the cleaning time; and/or determining, based on the temperature status information, the time at which a temperature value of the powered-on electronic device is lower than a preset temperature value as the cleaning time.

Other implementations of the present disclosure would readily occur to a person skilled in the art after considering the description and the practice of the disclosure disclosed herein. The present disclosure is intended to cover any variation, usage or adaptation change of the present disclosure, which follow the general principles of the present disclosure and include common general knowledge or customary technical means in the art that are not disclosed in the present disclosure. The description and embodiments are merely to be regarded exemplary, while the true scope of the present disclosure are indicated by the claims below.

It should be understood that the present disclosure is not limited to the precise structures described and shown in the accompanying drawings, and various modifications and changes may be made without departing from the scope thereof. The scope of the present disclosure is merely defined by the appended claims.

## Claims

1. An electronic device control method, comprising:
selecting (S110) a target mode from optional modes of a fan of an electronic device, the optional modes comprising a cleaning mode and a heat dissipation mode, wherein in the cleaning mode, the fan provides at least two different air strengths, and in the heat dissipation mode, the fan provides a single air strength when a heat dissipation level is not switched;
generating (S120) a control signal based on the target mode; and
controlling (S130), based on the control signal, the fan to provide an air strength;
wherein the method further comprises:
determining (S210) a cleaning delay; and
determining (S220) a cleaning time based on the cleaning delay;
wherein the determining (S210) a cleaning delay comprises at least one of:
determining the cleaning delay based on a randomized algorithm;
determining the cleaning delay based on a device number of the electronic device;
determining the cleaning delay based on a local area network address of the electronic device in a local area network where the electronic device is located; and
determining the cleaning delay based on a group number of a device group to which the electronic device belongs;
wherein the generating (S120) a control signal based on the target mode comprises:
obtaining a minimum air strength required to dissipate heat from the electronic device if the target mode is the cleaning mode; and
generating the control signal based on the minimum air strength required to dissipate heat from the electronic device, wherein the control signal controls a minimum air strength provided by the fan to be greater than or equal to the minimum air strength required to dissipate heat from the electronic device.

2. The method according to claim 1, wherein the generating (S120) a control signal based on the target mode comprises:
generating a first control signal if the target mode is the cleaning mode,
wherein the first control signal comprises at least two pulse width modulation, PWM, signals with different duty cycles; or
the first control signal comprises at least two direct current, DC, control signals with different high voltage values.

3. The method according to claim 1 or 2, wherein the generating (S120) a control signal based on the target mode comprises:
generating a second control signal if the target mode is the heat dissipation mode, wherein the second control signal is a PWM signal with a single duty cycle or a DC signal with a single voltage value.

4. The method according to claim 1 or 2, wherein the selecting (S110) a target mode from optional modes of a fan of an electronic device comprises:
selecting the cleaning mode as the target mode at the cleaning time; and
selecting the heat dissipation mode as the target mode at a time other than the cleaning time.

5. The method according to claim 1, wherein the determining (S210) a cleaning delay comprises at least one of:
determining the cleaning delay after the electronic device is powered on;
determining the cleaning delay after the electronic device is powered on and runs for a preset duration;
determining the cleaning delay after the electronic device has completed previous cleaning; and
determining the cleaning delay based on a predetermined period after the electronic device is powered on and has completed first-time cleaning.

6. The method according to claim 4, wherein running status information comprises load status information indicating a load status of the electronic device and/or temperature status information indicating an internal temperature status of the electronic device; and
the method further comprises:
determining, based on the load status information, a time at which a load rate of the electronic device is lower than a load threshold as the cleaning time;
and/or
determining, based on the temperature status information, the time at which a temperature value of the powered-on electronic device is lower than a preset temperature value as the cleaning time.

7. An electronic device control apparatus, comprising:
a selection module (110) configured to select a target mode from optional modes of a fan of an electronic device, the optional modes comprising a cleaning mode and a heat dissipation mode, wherein in the cleaning mode, the fan provides at least two different air strengths, and in the heat dissipation mode, the fan provides a single air strength when a heat dissipation level is not switched;
a generation module (120) configured to generate a control signal based on the target mode; and
a control module (130) configured to control, based on the control signal, the fan to provide an air strength;
wherein the apparatus further comprises:
a first determination module configured to determine a cleaning delay; and
a second determination module configured to determine a cleaning time based on the cleaning delay;
wherein the first determination module is specifically configured to perform at least one of operations of:
determining the cleaning delay based on a randomized algorithm;
determining the cleaning delay based on a device number of the electronic device;
determining the cleaning delay based on a local area network address of the electronic device in a local area network where the electronic device is located; and
determining the cleaning delay based on a group number of a device group to which the electronic device belongs;
wherein the generation module (120) is specifically configured to: obtain a minimum air strength required to dissipate heat from the electronic device if the target mode is the cleaning mode; and generate the control signal based on the minimum air strength required to dissipate heat from the electronic device, wherein the control signal controls a minimum air strength provided by the fan to be greater than or equal to the minimum air strength required to dissipate heat from the electronic device.

8. The apparatus according to claim 7, wherein the generation module (120) is specifically configured to generate a first control signal if the target mode is the cleaning mode,
wherein the first control signal comprises at least two pulse width modulation, PWM, signals with different duty cycles; or
the first control signal comprises at least two direct current, DC, control signals with different high voltage values.

9. The apparatus according to claim 7 or 8, wherein the generation module (120) is specifically configured to generate a second control signal if the target mode is the heat dissipation mode, wherein the second control signal is a PWM signal with a single duty cycle or a DC signal with a single voltage value;
wherein the selection module (110) is specifically configured to: select the cleaning mode as the target mode at the cleaning time; and select the heat dissipation mode as the target mode at a time other than the cleaning time.

10. The apparatus according to claim 7, wherein the first determination module is specifically configured to perform at least one of operations of:
determining the cleaning delay after the electronic device is powered on;
determining the cleaning delay after the electronic device is powered on and runs for a preset duration;
determining the cleaning delay after the electronic device has completed previous cleaning; and
determining the cleaning delay based on a predetermined period after the electronic device is powered on and has completed first-time cleaning.

11. The apparatus according to claim 9, wherein running status information comprises load status information indicating a load status of the electronic device and/or temperature status information indicating an internal temperature status of the electronic device; and
the apparatus further comprises a third determination module,
wherein the third determination module is specifically configured to: determine, based on the load status information, the time at which a load rate of the electronic device is lower than a load threshold as the cleaning time; and/or determine, based on the temperature status information, the time at which a temperature value of the powered-on electronic device is lower than a preset temperature value as the cleaning time.

12. A non-transitory computer-readable storage medium, **characterized by** storing instructions that, when executed by a processor of a computer, enable the computer to perform an electronic device control method according to any one of claims 1 to 6.

## Patentansprüche

1. Steuerverfahren für eine elektronische Vorrichtung, umfassend:
Auswählen (S110) eines Zielmodus aus optionalen Modi eines Lüfters einer elektronischen Vorrichtung, wobei die optionalen Modi einen Reinigungsmodus und einen Wärmeableitungsmodus umfassen, wobei der Lüfter im Reinigungsmodus mindestens zwei unterschiedliche Luftstärken bereitstellt und der Lüfter im Wärmeableitungsmodus eine einzelne Luftstärke bereitstellt, wenn nicht zwischen Wärmeableitungsstufen umgeschaltet wird;
Erzeugen (S120) eines Steuersignals basierend auf dem Zielmodus; und
Steuern (S130) des Lüfters basierend auf dem Steuersignal, um eine Luftstärke bereitzustellen;
wobei das Verfahren ferner Folgendes umfasst:
Bestimmen (S210) einer Reinigungsverzögerung; und
Bestimmen (S220) einer Reinigungszeit basierend auf der Reinigungsverzögerung;
wobei das Bestimmen (S210) einer Reinigungsverzögerung mindestens eines aus Folgendem umfasst:
Bestimmen der Reinigungsverzögerung basierend auf einem randomisierten Algorithmus;
Bestimmen der Reinigungsverzögerung basierend auf einer Vorrichtungsnummer der elektronischen Vorrichtung;
Bestimmen der Reinigungsverzögerung basierend auf einer lokalen Netzwerkadresse der elektronischen Vorrichtung in einem lokalen Netzwerk, in dem sich die elektronische Vorrichtung befindet; und
Bestimmen der Reinigungsverzögerung basierend auf einer Gruppennummer einer Vorrichtungsgruppe, zu der die elektronische Vorrichtung gehört;
wobei das Erzeugen (S120) eines Steuersignals basierend auf dem Zielmodus umfasst:
Erhalten einer Mindestluftstärke, die erforderlich ist, um Wärme von der elektronischen Vorrichtung abzuleiten, wenn der Zielmodus der Reinigungsmodus ist; und
Erzeugen des Steuersignals basierend auf der Mindestluftstärke, die erforderlich ist, um Wärme von der elektronischen Vorrichtung abzuleiten, wobei das Steuersignal bewirkt, dass die vom Lüfter bereitgestellte Mindestluftstärke größer oder gleich der zur Wärmeableitung von der elektronischen Vorrichtung erforderlichen Mindestluftstärke ist.

2. Verfahren nach Anspruch 1, wobei das Erzeugen (S120) eines Steuersignals basierend auf dem Zielmodus umfasst:
Erzeugen eines ersten Steuersignals, wenn der Zielmodus der Reinigungsmodus ist,
wobei das erste Steuersignal mindestens zwei Pulsweitenmodulationssignale (PWM-Signale) mit unterschiedlichen Tastverhältnissen umfasst; oder
das erste Steuersignal mindestens zwei Gleichstrom-Steuersignale (DC-Steuersignale) mit unterschiedlichen hohen Spannungswerten umfasst.

3. Verfahren nach Anspruch 1 oder 2, wobei das Erzeugen (S120) eines Steuersignals basierend auf dem Zielmodus umfasst:
Erzeugen eines zweiten Steuersignals, wenn der Zielmodus der Wärmeableitungsmodus ist, wobei das zweite Steuersignal ein PWM-Signal mit einem einzigen Tastverhältnis oder ein DC-Signal mit einem einzigen Spannungswert ist.

4. Verfahren nach Anspruch 1 oder 2, wobei das Auswählen (S110) eines Zielmodus aus optionalen Modi eines Lüfters einer elektronischen Vorrichtung umfasst:
Auswählen des Reinigungsmodus als Zielmodus zum Reinigungszeitpunkt; und
Auswählen des Wärmeableitungsmodus als Zielmodus zu einem anderen Zeitpunkt als der Reinigungszeit.

5. Verfahren nach Anspruch 1, wobei das Bestimmen (S210) einer Reinigungsverzögerung mindestens eines aus Folgendem umfasst:
Bestimmen der Reinigungsverzögerung nach dem Einschalten der elektronischen Vorrichtung;
Bestimmen der Reinigungsverzögerung nachdem die elektronische Vorrichtung eingeschaltet wurde und für eine voreingestellte Dauer in Betrieb war;
Bestimmen der Reinigungsverzögerung nach Abschluss der vorherigen Reinigung durch die elektronische Vorrichtung; und
Bestimmen der Reinigungsverzögerung basierend auf einem vorbestimmten Zeitraum nach Einschalten der elektronischen Vorrichtung und Abschluss einer erstmaligen Reinigung.

6. Verfahren nach Anspruch 4, wobei die Betriebszustandsinformationen Laststatusinformationen, die einen Laststatus der elektronischen Vorrichtung angeben, und/oder Temperaturstatusinformationen, die einen internen Temperaturstatus der elektronischen Vorrichtung angeben, umfassen; und
das Verfahren ferner umfasst:
Bestimmen, basierend auf den Laststatusinformationen, eines Zeitpunkts, zu dem eine Lastrate der elektronischen Vorrichtung niedriger als ein Lastschwellenwert ist, als die Reinigungszeit;
und/oder
Bestimmen, basierend auf den Temperaturstatusinformationen, des Zeitpunkts, zu dem ein Temperaturwert der eingeschalteten elektronischen Vorrichtung niedriger als ein voreingestellter Temperaturwert ist, als die Reinigungszeit.

7. Steuervorrichtung für eine elektronische Vorrichtung, umfassend:
ein Auswahlmodul (110), das so konfiguriert ist, dass es einen Zielmodus aus optionalen Modi eines Lüfters einer elektronischen Vorrichtung auswählt, wobei die optionalen Modi einen Reinigungsmodus und einen Wärmeableitungsmodus umfassen, wobei der Lüfter im Reinigungsmodus mindestens zwei verschiedene Luftstärken bereitstellt und der Lüfter im Wärmeableitungsmodus eine einzelne Luftstärke bereitstellt, wenn nicht zwischen Wärmeableitungsstufen umgeschaltet wird;
ein Erzeugungsmodul (120), das so konfiguriert ist, dass es ein Steuersignal basierend auf dem Zielmodus erzeugt;
und
ein Steuermodul (130), das so konfiguriert ist, dass es basierend auf dem Steuersignal den Lüfter steuert, um eine Luftstärke bereitzustellen;
wobei die Vorrichtung ferner umfasst:
ein erstes Bestimmungsmodul, das so konfiguriert ist, dass es eine Reinigungsverzögerung bestimmt; und
ein zweites Bestimmungsmodul, das so konfiguriert ist, dass es eine Reinigungszeit basierend auf der Reinigungsverzögerung bestimmt;
wobei das erste Bestimmungsmodul speziell dazu konfiguriert ist, mindestens einen der folgenden Vorgänge durchzuführen:
Bestimmen der Reinigungsverzögerung basierend auf einem randomisierten Algorithmus;
Bestimmen der Reinigungsverzögerung basierend auf einer Vorrichtungsnummer der elektronischen Vorrichtung;
Bestimmen der Reinigungsverzögerung basierend auf einer lokalen Netzwerkadresse der elektronischen Vorrichtung in einem lokalen Netzwerk, in dem sich die elektronische Vorrichtung befindet; und
Bestimmen der Reinigungsverzögerung basierend auf einer Gruppennummer einer Vorrichtungsgruppe, zu der die elektronische Vorrichtung gehört;
wobei das Erzeugungsmodul (120) speziell dazu konfiguriert ist, eine Mindestluftstärke zu erhalten, die erforderlich ist, um Wärme von der elektronischen Vorrichtung abzuleiten, wenn der Zielmodus der Reinigungsmodus ist; und das Steuersignal basierend auf der Mindestluftstärke zu erzeugen, die erforderlich ist, um Wärme von der elektronischen Vorrichtung abzuleiten, wobei das Steuersignal bewirkt, dass die vom Lüfter bereitgestellte Mindestluftstärke größer oder gleich der zur Wärmeableitung von der elektronischen Vorrichtung erforderlichen Mindestluftstärke ist.

8. Vorrichtung nach Anspruch 7, wobei das Erzeugungsmodul (120) speziell konfiguriert ist, ein erstes Steuersignal zu erzeugen, wenn der Zielmodus der Reinigungsmodus ist,
wobei das erste Steuersignal mindestens zwei Pulsweitenmodulationssignale (PWM-Signale) mit unterschiedlichen Tastverhältnissen umfasst; oder
das erste Steuersignal mindestens zwei Gleichstrom-Steuersignale (DC-Steuersignale) mit unterschiedlichen hohen Spannungswerten umfasst.

9. Vorrichtung nach Anspruch 7 oder 8, wobei das Erzeugungsmodul (120) speziell konfiguriert ist, ein zweites Steuersignal zu erzeugen, wenn der Zielmodus der Wärmeableitungsmodus ist, wobei das zweite Steuersignal ein PWM-Signal mit einem einzigen Tastverhältnis oder ein Gleichstromsignal mit einem einzigen Spannungswert ist;
wobei das Auswahlmodul (110) speziell dazu konfiguriert ist, den Reinigungsmodus zum Reinigungszeitpunkt als Zielmodus auszuwählen und den Wärmeableitungsmodus zu einem anderen Zeitpunkt als dem Reinigungszeitpunkt als Zielmodus auszuwählen.

10. Vorrichtung nach Anspruch 7, wobei das erste Bestimmungsmodul spezifisch dazu konfiguriert ist, mindestens einen der folgenden Vorgänge durchzuführen:
Bestimmen der Reinigungsverzögerung nach dem Einschalten der elektronischen Vorrichtung;
Bestimmen der Reinigungsverzögerung nachdem die elektronische Vorrichtung eingeschaltet wurde und für eine voreingestellte Dauer in Betrieb war;
Bestimmen der Reinigungsverzögerung nach Abschluss der vorherigen Reinigung durch die elektronische Vorrichtung; und
Bestimmen der Reinigungsverzögerung basierend auf einem vorbestimmten Zeitraum nach Einschalten der elektronischen Vorrichtung und Abschluss einer erstmaligen Reinigung.

11. Vorrichtung nach Anspruch 9, wobei Betriebszustandsinformationen Laststatusinformationen, die einen Laststatus der elektronischen Vorrichtung angeben, und/oder Temperaturstatusinformationen, die einen internen Temperaturstatus der elektronischen Vorrichtung angeben, umfassen; und
die Vorrichtung ferner ein drittes Bestimmungsmodul umfasst,
wobei das dritte Bestimmungsmodul speziell dazu konfiguriert ist, basierend auf den Laststatusinformationen einen Zeitpunkt, zu dem eine Lastrate der elektronischen Vorrichtung niedriger als ein Lastschwellenwert ist, als Reinigungszeitpunkt zu bestimmen; und/oder basierend auf den Temperaturstatusinformationen einen Zeitpunkt, zu dem ein Temperaturwert der eingeschalteten elektronischen Vorrichtung niedriger als ein voreingestellter Temperaturwert ist, als Reinigungszeitpunkt zu bestimmen.

12. Nichtflüchtiges computerlesbares Speichermedium, **dadurch gekennzeichnet, dass** es Anweisungen speichert, die, wenn sie von einem Prozessor eines Computers ausgeführt werden, es dem Computer ermöglichen, ein Steuerverfahren für eine elektronische Vorrichtung nach einem der Ansprüche 1 bis 6 durchzuführen.

## Revendications

1. Un procédé de commande de dispositif électronique, comprenant :
la sélection (S110) d'un mode cible parmi des modes optionnels d'un ventilateur d'un dispositif électronique, les modes optionnels comprenant un mode de nettoyage et un mode de dissipation de chaleur, dans lequel dans le mode de nettoyage, le ventilateur fournit au moins deux débits d'air différents, et dans le mode de dissipation de chaleur, le ventilateur fournit un seul débit d'air lorsqu'un niveau de dissipation de chaleur n'est pas commuté ;
la génération (S120) d'un signal de commande sur la base du mode cible ; et
la commande (S130), sur la base du signal de commande, du ventilateur pour qu'il fournisse un débit d'air ;
dans lequel le procédé comprend en outre :
la détermination (S210) d'un délai de nettoyage ; et
la détermination (S220) d'un moment du nettoyage sur la base du délai de nettoyage ;
dans lequel la détermination (S210) d'un délai de nettoyage comprenant au moins l'un des éléments suivants :
la détermination du délai de nettoyage sur la base d'un algorithme probabiliste ;
la détermination du délai de nettoyage sur la base d'un numéro de dispositif du dispositif électronique ;
la détermination du délai de nettoyage sur la base d'une adresse de réseau local du dispositif électronique dans un réseau local où le dispositif électronique est situé ; et
la détermination du délai de nettoyage sur la base d'un numéro de groupe d'un groupe de dispositifs auquel appartient le dispositif électronique ;
dans lequel la génération (S120) d'un signal de commande sur la base du mode cible comprend :
l'obtention d'un débit d'air minimal requis pour dissiper la chaleur du dispositif électronique si le mode cible est le mode de nettoyage ; et
la génération du signal de commande sur la base du débit d'air minimal requis pour dissiper la chaleur du dispositif électronique, dans lequel le signal de commande command un débit d'air minimal fourni par le ventilateur pour qu'il soit supérieur ou égal au débit d'air minimal requis pour dissiper la chaleur du dispositif électronique.

2. Le procédé selon la revendication 1, dans lequel la génération (S120) d'un signal de commande sur la base du mode cible comprend :
la génération d'un premier signal de commande si le mode cible est le mode de nettoyage,
dans lequel le premier signal de commande comprend au moins deux signaux de modulation de largeur d'impulsion, MLI, ayant des cycles de service différents ; ou
le premier signal de commande comprenant au moins deux signaux de commande à courant continu, CC, ayant des valeurs de haute tension différentes.

3. Le procédé selon la revendication 1 ou 2, dans lequel la génération (S120) d'un signal de commande sur la base du mode cible comprend :
la génération d'un second signal de commande si le mode cible est le mode de dissipation de chaleur, dans lequel le second signal de commande est un signal MLI ayant un seul cycle de service ou un signal CC ayant une seule valeur de tension.

4. Le procédé selon la revendication 1 ou 2, dans lequel la sélection (S110) d'un mode cible parmi des modes optionnels d'un ventilateur d'un dispositif électronique comprend :
la sélection du mode de nettoyage en tant que mode cible au moment du nettoyage ; et
la sélection du mode de dissipation de chaleur en tant que mode cible à un moment autre que le moment du nettoyage.

5. Le procédé selon la revendication 1, dans lequel la détermination (S210) d'un délai de nettoyage comprend au moins l'un des éléments suivants :
la détermination du délai de nettoyage après la mise sous tension du dispositif électronique ;
la détermination du délai de nettoyage après la mise sous tension du dispositif électronique et son fonctionnement pendant une durée prédéfinie ;
la détermination du délai de nettoyage après la réalisation par le dispositif électronique du nettoyage précédent ;
et
la détermination du délai de nettoyage sur la base d'une période prédéterminée après la mise sous tension du dispositif électronique et la réalisation de son premier nettoyage.

6. Le procédé selon la revendication 4, dans lequel les informations d'état de fonctionnement comprennent des informations d'état de charge indiquant un état de charge du dispositif électronique et/ou des informations d'état de température indiquant un état de température interne du dispositif électronique ; et
le procédé comprenant en outre :
la détermination, sur la base des informations d'état de charge, d'un moment auquel un taux de charge du dispositif électronique est inférieur à un seuil de charge en tant que moment du nettoyage ;
et/ou
la détermination, sur la base des informations d'état de température, du moment auquel une valeur de température du dispositif électronique sous tension est inférieure à une valeur de température prédéfinie en tant que moment du nettoyage.

7. Un dispositif de commande de dispositif électronique, comprenant :
un module de sélection (110) configuré pour sélectionner un mode cible parmi des modes optionnels d'un ventilateur d'un dispositif électronique, les modes optionnels comprenant un mode de nettoyage et un mode de dissipation de chaleur, dans lequel dans le mode de nettoyage, le ventilateur fournit au moins deux débits d'air différents, et dans le mode de dissipation de chaleur, le ventilateur fournit un seul débit d'air lorsqu'un niveau de dissipation de chaleur n'est pas commuté ;
un module de génération (120) configuré pour générer un signal de commande sur la base du mode cible ; et
un module de commande (130) configuré pour commander, sur la base du signal de commande, le ventilateur pour qu'il fournisse un débit d'air ;
dans lequel le dispositif comprend en outre :
un premier module de détermination configuré pour déterminer un délai de nettoyage ; et
un deuxième module de détermination configuré pour déterminer un moment de nettoyage sur la base du délai de nettoyage ;
dans lequel le premier module de détermination est spécifiquement configuré pour effectuer au moins l'une des opérations suivantes :
la détermination du délai de nettoyage sur la base d'un algorithme probabiliste ;
la détermination du délai de nettoyage sur la base d'un numéro de dispositif du dispositif électronique ;
la détermination du délai de nettoyage sur la base d'une adresse de réseau local du dispositif électronique dans un réseau local où le dispositif électronique est situé ; et
la détermination du délai de nettoyage sur la base d'un numéro de groupe d'un groupe de dispositifs auquel appartient le dispositif électronique ;
dans lequel le module de génération (120) est spécifiquement configuré pour : obtenir un débit d'air minimal requis pour dissiper la chaleur du dispositif électronique si le mode cible est le mode de nettoyage ; et générer le signal de commande sur la base du débit d'air minimal requis pour dissiper la chaleur du dispositif électronique, dans lequel le signal de commande command un débit d'air minimal fourni par le ventilateur pour qu'il soit supérieur ou égal au débit d'air minimal requis pour dissiper la chaleur du dispositif électronique.

8. Le dispositif selon la revendication 7, dans lequel le module de génération (120) est spécifiquement configuré pour générer un premier signal de commande si le mode cible est le mode de nettoyage,
dans lequel le premier signal de commande comprend au moins deux signaux de modulation de largeur d'impulsion, MLI, ayant des cycles de service différents ; ou
le premier signal de commande comprenant au moins deux signaux de commande à courant continu, CC, ayant des valeurs de haute tension différentes.

9. Le dispositif selon la revendication 7 ou 8, dans lequel le module de génération (120) est spécifiquement configuré pour générer un second signal de commande si le mode cible est le mode de dissipation de chaleur, dans lequel le second signal de commande est un signal MLI ayant un seul cycle de service ou un signal CC ayant une seule valeur de tension ;
dans lequel le module de sélection (110) est spécifiquement configuré pour : sélectionner le mode de nettoyage en tant que mode cible au moment du nettoyage ; et sélectionner le mode de dissipation de chaleur en tant que mode cible à un moment autre que le moment du nettoyage.

10. Le dispositif selon la revendication 7, dans lequel le premier module de détermination est spécifiquement configuré pour effectuer au moins l'une des opérations suivantes :
la détermination du délai de nettoyage après la mise sous tension du dispositif électronique ;
la détermination du délai de nettoyage après la mise sous tension du dispositif électronique et son fonctionnement pendant une durée prédéfinie ;
la détermination du délai de nettoyage après la réalisation par le dispositif électronique du nettoyage précédent ;
et
la détermination du délai de nettoyage sur la base d'une période prédéterminée après la mise sous tension du dispositif électronique et la réalisation de son premier nettoyage.

11. Le dispositif selon la revendication 9, dans lequel les informations d'état de fonctionnement comprennent des informations d'état de charge indiquant un état de charge du dispositif électronique et/ou des informations d'état de température indiquant un état de température interne du dispositif électronique ; et
le dispositif comprenant en outre un troisième module de détermination,
dans lequel le troisième module de détermination est spécifiquement configuré pour : déterminer, sur la base des informations d'état de charge, que le moment auquel un taux de charge du dispositif électronique est inférieur à un seuil de charge est le moment du nettoyage ; et/ou déterminer, sur la base des informations d'état de température, que le moment auquel une valeur de température du dispositif électronique sous tension est inférieure à une valeur de température prédéfinie est le moment du nettoyage.

12. Un support de stockage lisible par ordinateur non transitoire, **caractérisé par** le stockage d'instructions qui, lorsqu'elles sont exécutées par un processeur d'un ordinateur, amènent l'ordinateur à mettre en œuvre un procédé de commande de dispositif électronique selon l'une quelconque des revendications 1 à 6.
